# EUROPÄISCHE PATENTSCHRIFT

(11) **EP 3 721 473 B1**
(45) Veröffentlichungstag und Bekanntmachung des Hinweises auf die Patenterteilung: **02.03.2022**
(21) Anmeldenummer: 19702004.3
(22) Anmeldetag: 14.01.2019
(51) Int. Cl.: H01L 25/18, H05K 7/02, H05K 1/18, H01L 25/16, H01L 23/64, H01L 25/10, H01L 25/07, H01L 23/00

(54) **LEISTUNGSELEKTRONISCHE SCHALTUNG MIT MEHREREN LEISTUNGSMODULEN**
POWER ELECTRONIC CIRCUIT HAVING A PLURALITY OF POWER MODULES
CIRCUIT ÉLECTRONIQUE DE PUISSANCE COMPORTANT UNE PLURALITÉ DE MODULES DE PUISSANCE

(30) Priorität: 06.02.2018 DE 102018201842
(43) Veröffentlichungstag der Anmeldung: 14.10.2020
(73) Patentinhaber: Siemens Aktiengesellschaft, 80333 München (DE)
(72) Erfinder: HEIMANN, Matthias, 14469 Potsdam (DE); MEYRATH, Wilhelm, 1220 Wien (AT); MÜLLER, Bernd, 16259 Falkenberg (DE); PFLEGER, Franz, 1030 Wien (AT); PRANKH, Peter, 2301 Groß-Enzersdorf (AT); STROGIES, Jörg, 14163 Berlin (DE); WILKE, Klaus, 12527 Berlin (DE)
(86) Internationale Anmeldenummer: PCT/EP2019/050781
(87) Internationale Veröffentlichungsnummer: WO 2019/154592

(56) Entgegenhaltungen:
- CN-U- 206 117 523
- DE-B3-102014 101 024
- US-A1- 2002 088 977

## Beschreibung

Die Erfindung betrifft eine leistungselektronische Schaltung mit einer Vielzahl von miteinander verschalteten Leistungsmodulen nach Anspruch 1 . Die Leistungsmodule weisen jeweils mindestens ein leistungselektronisches Bauelement auf. Mehrere parallel geschaltete und mit dem mindestens einen leistungselektronischen Bauelement elektrisch verbundene Kondensatoren sind als weiterer Teil der Leistungsmodule ausgeführt.

Leistungselektronische Schaltungen sind üblicherweise auf einen zugehörigen gegebenen Anwendungsfall anzupassen. Diese Anwendungsfälle unterscheiden sich individuell, wodurch bei der Auslegung der leistungselektronischen Schaltungen und bei deren Herstellung ein beträchtlicher Aufwand entsteht. Die individuellen Anwendungsfälle stehen insbesondere einer Automatisierbarkeit der Herstellung von Leistungsmodulen im Wege. Insbesondere erzeugt die Verwendung von Kondensatoren einen erhöhten Montageaufwand, da erforderliche Kapazitätswerte nur durch eine Parallelschaltung mehrerer Kondensatoren erreicht werden können, wobei diese alle in die leistungselektronische Schaltung integriert werden müssen.

Die DE 10 2014 101 024 B3 offenbart eine Leistungshalbleitereinrichtung mit Leistungshalbleiterbauelementen, mit einem Grundkörper und mit mehreren Kondensatoren, wobei die Leistungshalbleitereinrichtung eine Kondensatorbefestigungsvorrichtung aufweist.

Die CN 206 117 523 U offenbart ein Leistungshalbleitermodul mit einer IGBT Gruppe und einer Kondensatorengruppe.

Die US 2002/088977 A1 offenbart gestapelte Kondensatoren und eine damit bestückte Leiterplatte.

Die Aufgabe der Erfindung besteht darin, eine leistungselektronische Schaltung dahingehend zu verbessern, dass diese sich mit einem verringerten Aufwand bei der Konzeption bzw. bei der Herstellung erzeugen lässt, insbesondere bei Einzelanfertigungen von Leistungsmodulen bzw. geringen Stückzahlen.

Diese Aufgabe wird mit der eingangs angegebenen elektronischen Schaltung erfindungsgemäß dadurch gelöst, dass die Leistungsmodule derart ausgebildet sind, dass die leistungselektronischen Bauelemente auf der einen Seite von Substratplatten montiert sind. Die Kondensatoren sind in mehreren Ebenen übereinander auf der anderen Seite der Substratplatten montiert. Außerdem sind die Substratplatten mit den leistungselektronischen Bauelementen voran nebeneinander auf der Montageseite eines Basisschaltungsträgers befestigt.

Die leistungselektronischen Bauelemente sind vorzugsweise als Nacktchip ausgeführt. Dieser lässt sich direkt mit der Substratplatte kontaktieren, beispielsweise durch eine Sinterverbindung, die auch einen elektrischen Kontakt gewährleistet. Die Substratplatte kann vorzugsweise aus einer Keramik hergestellt sein. Diese leitet den elektrischen Strom nicht, so dass gleichzeitig eine elektrische Isolation gewährleistet ist. Daher kann eine elektronische Schaltung durch Strukturieren einer elektrisch leitenden Beschichtung auf der Substratplatte realisiert werden. Hierdurch werden beispielsweise Kontaktflächen zur Kontaktierung der leistungselektronischen Bauelemente zur Verfügung gestellt.

Die erfindungsgemäße Ausbildung der Leistungsmodule hat den Vorteil, dass diese mit vergleichsweise geringem Aufwand bei der Konzipierung und bei der Montage auf dem Basisschaltungsträger zu verschiedenen Konfigurationen kombiniert werden können, um leistungselektronische Schaltungen mit unterschiedlichen Anforderungen zu realisieren. Der Basisschaltungsträger kann dabei beispielsweise als Leiterplatte ausgebildet sein, wobei eine Schaltung auf der Oberfläche zur Kontaktierung mit den verwendeten Leistungsmodulen vorgesehen sein kann. Der Basisschaltungsträger kann beispielsweise aber auch aus einem Gehäuseteil oder dergleichen bestehen, wobei das Gehäuse dann gleichzeitig als Tragkörper zur Ausbildung der leistungselektronischen Schaltung dient.

Dadurch, dass die Kondensatoren in mehreren Ebenen übereinander auf der anderen Seite der Substratplatten angeordnet sind, lassen sich vorteilhaft sehr kurze elektrische Verbindungswege zwischen den Kondensatoren und den leistungselektronischen Bauelementen realisieren. Dabei können die Kondensatoren vorzugsweise parallel geschaltet sein, so dass sich mit vergleichsweise kostengünstigen Bauteilen vergleichsweise hohe Kapazitäten der Kondensatoranordnungen erreichen lassen. Dabei kann die Entstehung von parasitären Induktivitäten vorteilhaft vergleichsweise gering gehalten werden.

Die Anordnung der Kondensatoren in mehreren Ebenen kann beispielsweise durch Stapeln dieser Kondensatoren erreicht werden. Diese weisen Kondensatorelektroden auf, mit denen sie in einer geeigneten Haltevorrichtung gehalten werden können. Eine andere Möglichkeit besteht darin, die Kondensatoren auf Schaltungsträgern zu montieren und diese Schaltungsträger aufeinander zu stapeln, so dass die auf diesen montierten Kondensatoren in mehreren Ebenen übereinander liegen. Die Schaltungsträger werden dabei als Zwischenschaltungsträger verwendet (hierzu im Folgenden noch mehr).

Gemäß einer vorteilhaften Ausgestaltung der Erfindung ist vorgesehen, dass die Leistungsmodule in einer Reihe angeordnet sind. Eine solche gleichmäßige Anordnung hat den Vorteil, dass die Auslegung solcher elektronischen Schaltungen vorteilhaft vereinfacht wird. Zum einen kann beispielsweise schnell berechnet werden, wie ein zur Verfügung stehender Bauraum optimal genutzt werden kann. Außerdem begünstigt die gleichmäßige Anordnung der Leistungsmodule, dass diese auch gleichmäßig gekühlt werden können. Zuletzt lassen sich die elektrischen Verbindungswege zwischen den einzelnen Modulen vorteilhaft verkürzen.

Gemäß einer weiteren Ausgestaltung der Erfindung ist vorgesehen, dass die Leistungsmodule in einem zweidimensionalen Array in einer Vielzahl benachbarter Reihen angeordnet sind. Für diese Anordnung gelten die vorstehend genannten Vorteile einer Anordnung in Reihen in gleicher Weise. Dies bedeutet, dass einerseits kurze Verbindungswege zwischen den einzelnen Modulen realisiert werden können. Außerdem begünstigt die regelmäßige Anordnung der Leistungsmodule in einem Array eine optimale Platzausnutzung eines zur Verfügung stehenden Bauraums.

Eine andere Ausgestaltung der Erfindung sieht vor, dass ein Trägerbauteil für eine Zusatzfunktion vorgesehen ist, welches zumindest mit einem Teil der Leistungsmodule mechanisch verbunden ist. Als Trägerbauteil im Sinne der Erfindung ist somit ein Bauteil zu verstehen, was ein für eine Zusatzfunktion verantwortliches Bauelement trägt oder diese Zusatzfunktion selbst realisiert. Eine mechanische Verbindung dieses Trägerbauteils mit einem Teil der Leistungsmodule oder allen Leistungsmodulen bewirkt, dass eine Zuordnung der Zusatzfunktion zu bestimmten oder allen Leistungsmodulen möglich ist. Diese Zuordnung kann beispielsweise durch eine elektrische Kontaktierung erfolgen. In diesem Fall ist das Trägerbauteil selbst ebenfalls als Zusatzschaltungsträger ausgeführt. "Ein Teil der Leistungsmodule" kann im Sinne der Erfindung auch "ein Leistungsmodul" oder "mehrere, also mindestens zwei Leistungsmodule" bedeuten.

Eine wieder andere Ausgestaltung der Erfindung sieht vor, dass das Trägerbauteil auf den dem Basisschaltungsträger abgekehrten Seiten der Leistungsmodule befestigt ist. Mit anderen Worten liegt das Trägerbauteil dann dem Basisschaltungsträger gegenüber. Dies bedeutet, dass die Leistungsmodule sich zwischen dem Basisschaltungsträger und dem Trägerbauteil befinden. Die Seite, mit der die Leistungsmodule auf dem Basisschaltungsträger montiert werden, liegt also der Seite, auf der nach dieser Ausgestaltung der Erfindung das Trägerbauteil aufgesetzt wird, gegenüber.

Das Trägerbauteil kann bei dieser geometrischen Konfiguration vorteilhaft eine vergleichsweise große Fläche zur Verfügung stellen, auf der die Zusatzfunktion vorgesehen werden kann. Insbesondere kann die Zusatzfunktion aus zusätzlichen elektronischen Bauelementen bestehen, wobei das Trägerbauteil in diesem Fall als Schaltungsträger ausgeführt ist. Das Trägerbauteil kann insbesondere in der Verbindungsebene zwischen Leistungsmodulen und Trägerbauteil dieselben Abmessungen aufweisen, wie der Basisschaltungsträger in der Verbindungsebene zwischen Leistungsmodulen und Basisschaltungsträger. Die Fläche, die dann für Zusatzfunktionalitäten zu Verfügung steht, ist damit vergleichsweise groß.

Vorteilhaft kann das zuletzt beschriebene Trägerbauteil auch aus einem Zwischenschaltungsträger bestehen. Dieser ist dadurch definiert, dass auf einer den leistungselektronischen Bauelementen abgekehrten Seite des Zwischenschaltungsträgers mehrere parallel geschaltete und mit dem mindestens einen leistungselektronischen Bauelement elektrisch verbundene Kondensatoren montiert sind. Mit anderen Worten ist es möglich, mittels des Zwischenschaltungsträgers die Kondensatoren, die für ein bestimmtes leistungselektronisches Bauelement erforderlich sind, nicht nur auf der Substratplatte, sondern auch auf einem darüber liegenden Zwischenschaltungsträger zu montieren und elektrisch zu kontaktieren. Hierdurch lassen sich vorteilhaft ein mechanisch stabiler Bauteilverbund und eine elektrisch zuverlässige Kontaktierung erzeugen. Die Zwischenschaltungsträger können überdies zur Unterbringung von Zusatzfunktionalitäten verwendet werden, wobei insbesondere eine elektrische Kontaktierung dieser Zusatzfunktionalitäten möglich ist.

Vorteilhaft kann natürlich auf den Kondensatoren des Zwischenschaltungsträgers mindestens ein weiteres Trägerbauteil für eine Zusatzfunktion befestigt sein. Dieses weitere Trägerbauteil kann selbst ein weiterer Zwischenschaltungsträger sein, auf dem weitere Kondensatoren auf der den leistungselektronischen Bauelementen abgekehrten Seite dieses Zwischenschaltungsträgers montiert sind. Diese sind dann, wie bereits beschrieben, parallel geschaltet und mit dem mindestens einen leistungselektronischen Bauelement elektrisch verbunden. Die Unterbringung von zusätzlichen Kondensatoren ist im Sinne der Erfindung somit auch als Zusatzfunktion zu verstehen. Natürlich können auch andere Zusatzfunktionen auf dem weiteren Trägerbauteil vorgesehen sein (zusätzlich zu den Kondensatoren oder alternativ). Weitere Zusatzfunktionen könnten beispielsweise eine Treiberschaltung für das darunter liegende leistungselektronische Bauelement sein.

Eine alternative Möglichkeit besteht gemäß einer anderen Ausgestaltung der Erfindung darin, dass das Trägerbauteil sich entlang benachbarter Leistungsmodule erstreckt und an jeweiligen durch diese gebildeten Seitenflächen befestigt ist. Als Seitenflächen im Sinne der Erfindung sind diejenigen Flächen zu verstehen, welche sich bezogen auf ein auf dem Basisschaltungsträger montiertes Leistungsmodul seitlich erstrecken. Der Basisschaltungsträger ergibt somit die Bezugsfläche und die Seitenflächen erstrecken sich sozusagen von diesem weg, vorzugsweise in einem Winkel von 90°, wenn das Leistungsmodul eine im Wesentlichen quaderförmige Gestalt aufweist.

Mit dem letztgenannten Trägerbauteil lassen sich benachbarte Leistungsmodule, die in einer Reihe nebeneinander liegen, miteinander verbinden. Dies hat den Vorteil, dass eine mechanische Stabilisierung erfolgt. Außerdem wird der Montageaufwand im Vergleich zur Verwendung von individuellen Trägerbauteilen für jedes einzelne Modul deutlich verringert. Funktionalitäten wie beispielsweise eine Kühlung lassen sich dadurch mit einem vergleichsweise geringen Montageaufwand erzeugen. Insbesondere bei aktiven Kühlern, die durch einen Kühlmedium, insbesondere eine Kühlflüssigkeit wie Kühlwasser, durchflossen werden, verringert sich der Montageaufwand beträchtlich, da insgesamt weniger Anschlüsse für das Kühlmittel zu verbinden sind. Dies verbessert auch die Zuverlässigkeit hinsichtlich eventueller Undichtigkeiten des Kühlers.

Wie bereits erwähnt, kann das Trägerbauteil als Zusatzfunktion eine Schaltung tragen. In diesem Fall ist das Trägerbauteil gemäß einer vorteilhaften Ausgestaltung der Erfindung als Zusatzschaltungsträger ausgeführt. Die Schaltung kann verschiedene Aufgaben erfüllen. Beispielsweise kann es sich bei der Schaltung um eine Treiberschaltung für die leistungselektronische Schaltung und/oder zumindest ein Teil der Leistungsmodule handeln. Die Treiberschaltung für die leistungselektronische Schaltung des jeweiligen Leistungsmoduls steuert das mindestens eine leistungselektronische Bauelement an, damit dieses seine vorgesehene Funktionalität erfüllt. Eine Treiberschaltung für zumindest einen Teil der Leistungsmodule der leistungselektronischen Schaltung, vorzugsweise alle Leistungsmodule der leistungselektronischen Schaltung kann verwendet werden, um ein Betriebsregime für die leistungselektronische Schaltung zu verwirklichen. Bei diesem Betriebsregime können abhängig vom Betriebszustand Leistungsmodule zu- oder abgeschaltet werden, um beispielsweise einen Volllast- oder einen Teillastbetrieb zu gewährleisten. Dabei kann während des Teillastbetriebs vorteilhaft Energie gespart werden und damit der Wirkungsgrad der leistungselektronischen Schaltung verbessert werden.

Eine andere Möglichkeit besteht vorteilhaft darin, dass das Trägerbauteil als Zusatzfunktion mindestens ein Sensorelement aufweist. Dieses kann insbesondere ein Temperatursensor und/oder ein Feuchtigkeitssensor und/oder ein Stromsensor und/oder ein Beschleunigungssensor sein.

Temperatursensoren kommen beispielsweise zum Einsatz, damit die Betriebstemperatur der Leistungsmodule überwacht werden kann. Dies ermöglicht beispielsweise ein rechtzeitiges Abschalten, um eine Überlastung oder Beschädigung des Leistungsmoduls zu verhindern. Ein Temperatursensor kann aber auch zum Einsatz kommen, um die Umgebungstemperatur der leistungselektronischen Schaltung zu bestimmen, und beispielsweise das voraussichtliche Kühlungsverhalten zu bestimmen. Feuchtigkeitssensoren können verwendet werden, um die Betriebsbedingungen für die leistungselektronische Schaltung zu überwachen. Bei einer zu hohen Feuchtigkeit muss die leistungselektronische Schaltung getrocknet werden, bevor ein Betrieb oder Weiterbetrieb möglich ist. Eine zu hohe Feuchtigkeit kann beispielsweise bei niedrigen Außentemperaturen durch die Bildung von Tau entstehen. Eine andere Möglichkeit besteht darin, dass eine Wasserkühlung undicht geworden ist.

Stromsensoren kommen zum Einsatz, um den Betriebszustand der leistungselektronischen Schaltung zu überwachen. Beispielsweise kann die Strombelastung in den einzelnen Leistungsmodulen miteinander verglichen werden. Eine Strommessung kann beispielsweise auch für einen Betrieb einer Treiberschaltung für die Leistungsmodule erforderlich sein (hierzu im Folgenden noch mehr).

Das Sensorelement kann vorteilhaft auch als Beschleunigungssensor ausgebildet sein. Beschleunigungssensoren ermöglichen vorteilhaft die Ermittlung von mechanischen Beanspruchungen der leistungselektronischen Schaltung. Beispielsweise können Ereignisse aufgezeichnet werden, welche einen Weiterbetrieb der leistungselektronischen Schaltung ausschließen, bevor eine Wartung vorgenommen wurde, beispielsweise weil die leistungselektronische Schaltung bei einem mobilen Einsatz heruntergefallen ist. Beschleunigungssensoren können aber auch verwendet werden, um beispielsweise Vibrationen zu ermitteln. Abhängig von Häufigkeit und Stärke der Vibration können z. B. flexible Wartungsintervalle für die leistungselektronische Schaltung ausgegeben werden.

Gemäß einer anderen Ausgestaltung der Erfindung ist vorgesehen, dass das Trägerbauteil als Zusatzfunktion eine mechanische Versteifungsstruktur, insbesondere Rippen, aufweist. Rippen eignen sich vorteilhaft dazu, mit einfachen Mitteln eine höhere mechanische Belastbarkeit der leistungselektronischen Schaltung zu erreichen. Das Trägerbauteil verbindet, wie bereits beschrieben, in bevorzugten Ausführungsformen der Erfindung mehrere Leistungsmodule miteinander, wobei die mechanische Versteifungsstruktur Relativbewegungen der Leistungsmodule untereinander verringert und damit zu einer Versteifung der leistungselektronischen Schaltung beiträgt. Dieser Versteifungseffekt lässt sich mit einem vergleichsweise geringen Fertigungs- und Montageaufwand erreichen.

Besonders vorteilhaft ist eine leistungselektronische Schaltung, bei der jedes Leistungsmodul zwei als Schaltelemente ausgeführte leistungselektronische Bauelemente aufweist. Solche Leistungsmodule können derart kontaktiert werden, dass die leistungselektronischen Bauelemente jedes Leistungsmoduls eine Halbbrücke bilden. Dabei werden je eine Elektrode der beiden leistungselektronischen Bauelemente zusammengeführt. Die Halbbrücke ist vorteilhaft mit einer Kontaktierungsmöglichkeit für einen externen Anschluss ausgeführt. Außerdem sind die leistungselektronischen Bauelemente der bevorzugten leistungselektronischen Schaltung in drei Gruppen miteinander verschaltet. Diese Verschaltung ist so ausgebildet, dass jede Gruppe eine Phase eines dreiphasigen Wechselstroms zugeordnet ist, wobei jede Gruppe mit einem Gleichstrom beaufschlagbar ist. Die jeweilige Phase des dreiphasigen Wechselstroms wird über die Halbbrücken der jeweiligen Gruppe von leistungselektronischen Bauelementen abgegriffen. Der Gleichstrom wird jeweils über die noch freien Elektroden der jeweiligen leistungselektronischen Bauelemente herangeführt (hierzu im Folgenden noch mehr).

Weitere Einzelheiten der Erfindung werden nachfolgend anhand der Zeichnung beschrieben. Gleiche oder sich entsprechende Zeichnungselemente sind jeweils mit den gleichen Bezugszeichen versehen und werden nur insoweit mehrfach erläutert, wie sich Unterschiede zwischen den einzelnen Figuren ergeben.

Bei den im Folgenden erläuterten Ausführungsbeispielen handelt es sich um bevorzugte Ausführungsformen der Erfindung. Des Weiteren sind die beschriebenen Ausführungsformen auch durch weitere der bereits beschriebenen Merkmale der Erfindung ergänzbar.

Es zeigen:
- Figur 1: ein Leistungsmodul, wie es in einem Ausführungsbeispiel der erfindungsgemäßen leistungselektronischen
- Figur 2: Schaltung eingebaut werden kann, in dreidimensionaler Ansicht, teilweise geschnitten, das Detail II gemäß Figur 1, teilweise aufgeschnitten,
- Figur 3: ein Ausführungsbeispiel der erfindungsgemäßen leistungselektronischen Schaltung mit einer Vielzahl von Leistungsmodulen, die gemäß Figur 1 oder ähnlich aufgebaut sein können, als schematische Aufsicht,
- Figur 4: schematisch einen beispielhaften, nicht beanspruchten Schaltplan für eine Kontaktierung von Leistungsmodulen gemäß Figur 1 in einer leistungselektronischen Schaltung gemäß Figur 3,
- Figur 5: ein anderes Ausführungsbeispiel für einen Kondensatoraufbau, wie dieser in einem Leistungsmodul gemäß Figur 1 zum Einsatz kommen kann, in dreidimensionaler Darstellung, teilweise aufgeschnitten,
- Figur 6: ein Ausführungsbeispiel des erfindungsgemäßen Leistungsmoduls mit seitlich angebrachten Trägerbauteilen als Seitenansicht, teilweise aufgeschnitten,
- Figur 7: ein Ausführungsbeispiel der erfindungsgemäßen leistungselektronischen Schaltung mit Zwischenschaltungsträgern als Trägerbauteile in einer Seitenansicht.

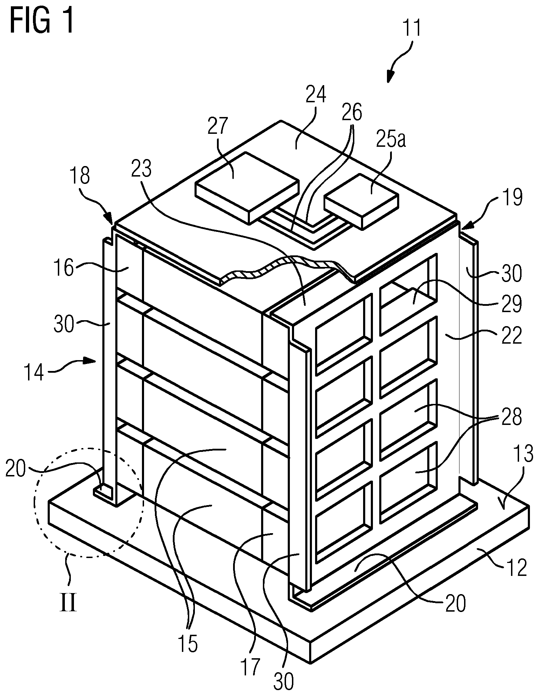

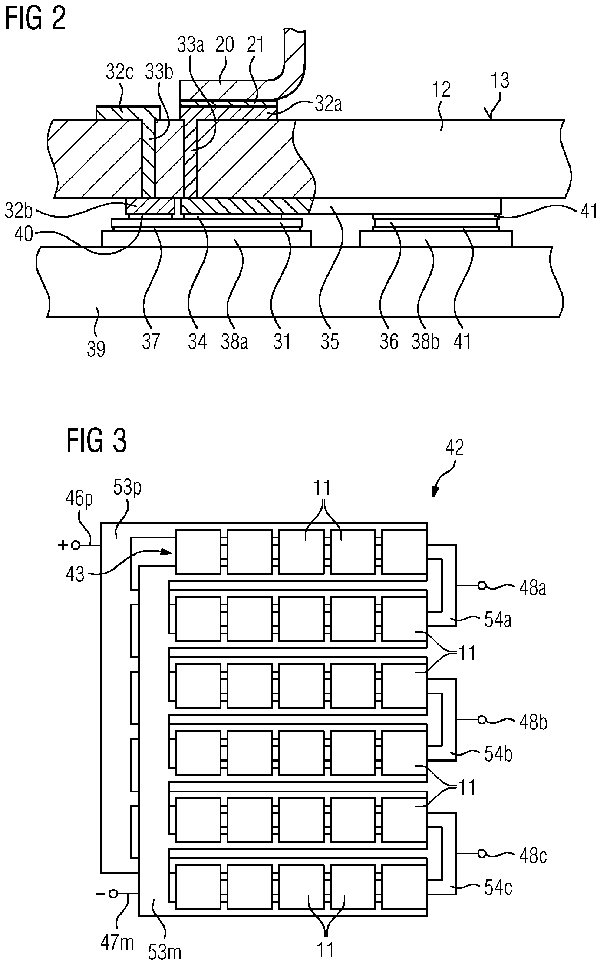

Ein Leistungsmodul 11 gemäß Figur 1 weist eine Substratplatte 12 auf, auf deren sichtbarer Oberseite 13 ein Kondensatoraufbau 14 nach einem Verfahren der Oberflächenmontage montiert wurde. Der Kondensatoraufbau weist acht Kondensatoren 15 auf, von denen in Figur 1 jedoch nur sieben dargestellt sind (der rechts oben angeordnete Kondensator fehlt; hierzu im Folgenden noch mehr). Die Kondensatoren 15 weisen jeweils erste Kondensatorelektroden 16 und zweite Kondensatorelektroden 17 auf, wobei die ersten Kondensatorelektroden 16 mit einer ersten Elektrode 18 und die zweiten Kondensatorelektroden 17 mit einer zweiten Elektrode 19 durch nicht näher dargestellte Lötverbindungen oder eine andere soff- oder formschlüssige Verbindung elektrisch kontaktiert sind. Die erste Elektrode 18 und die zweite Elektrode 19 weisen überdies je eine Kontaktstruktur 20 auf, die mit ihren unteren Seiten an der ersten Elektrode eine erste Anschlussfläche und an der zweiten Elektrode eine zweite Anschlussfläche bilden (in Figur 1 nicht zu erkennen, da der Oberseite 13 zugewandt). Mit der ersten Anschlussfläche und der zweiten Anschlussfläche, die gemeinsam die Montageseite des Kondesatoraufbaus 14 ausbilden, ist dieser auf die Oberseite der Substratplatte 12 mittels einer nicht näher dargestellten Lötverbindung oder einer anderen elektrischen Verbindung 21 (vgl. Figur 2) montiert.

Die erste Elektrode 18 und die zweite Elektrode 19 bilden gemeinsam eine Haltestruktur für die Kondensatoren 15 aus. Da die Kondensatoren 15 mit ihren ersten Kontaktelektroden 16 und ihren zweiten Kontaktelektroden 17 mit Seitenwänden 22 der ersten Elektrode 18 und zweiten Elektrode 19 verbunden sind, entsteht der selbsttragende Kondensatoraufbau 14, obwohl die erste Elektrode 18 und die zweite Elektrode 19 nicht direkt miteinander verbunden sind. Zusätzliche Stabilität erlangt der Kondensatoraufbau 11 durch Montage auf der Substratplatte 12. Außerdem ist auf Aufnahmestrukturen 23 der ersten Elektrode 18 und der zweiten Elektrode 19 ein Schaltungsträger 24 als zusätzliche Baustruktur befestigt, wobei der Schaltungsträger 24 eine Verbindung zwischen der ersten Elektrode 18 und der zweiten Elektrode 19 herstellt und damit die Haltestruktur stabilisiert.

In der Seitenwand 22 der ersten Elektrode 18 (nicht zu erkennen in Figur 1) und der zweiten Elektrode 19 sind Fenster 28 eingestanzt. Diese eröffnen die Möglichkeit, Zungen 29 in den Innenraum der Haltestruktur hinein zu biegen, die eine Positionierung der Kondensatoren 15 erleichtern und überdies die elektrische Kontaktfläche vergrößern. Da der rechts oben befindliche Kondensator hinter der Seitenwand 22 weggelassen wurde, kann die Zunge 29 dort dargestellt werden. In den anderen Fenstern sind die Zungen von den zweiten Kondensatorelektroden 17 verdeckt.

Auf dem Schaltungsträger 24 ist ein Sensorelement 25a befestigt, wobei es sich beispielsweise um einen Temperatursensor, Feuchtesensor, Gassensor oder einen Beschleunigungssensor handelt. Über Leiterbahnen 26 auf dem Schaltungsträger 24 ist das Sensorelement 25a mit einer Auswertungsschaltung z.B. in Form eines integrierten Schaltkreises 27 verbunden. Der integrierte Schaltkreis 27 kann das Sensorsignal auswerten und in nicht näher dargestellter Weise für eine Weiterverarbeitung zur Verfügung stellen (beispielsweise über nicht dargestellte Leitungsverbindungen oder eine schnurlose Schnittstelle, also über Funk oder Infrarot).

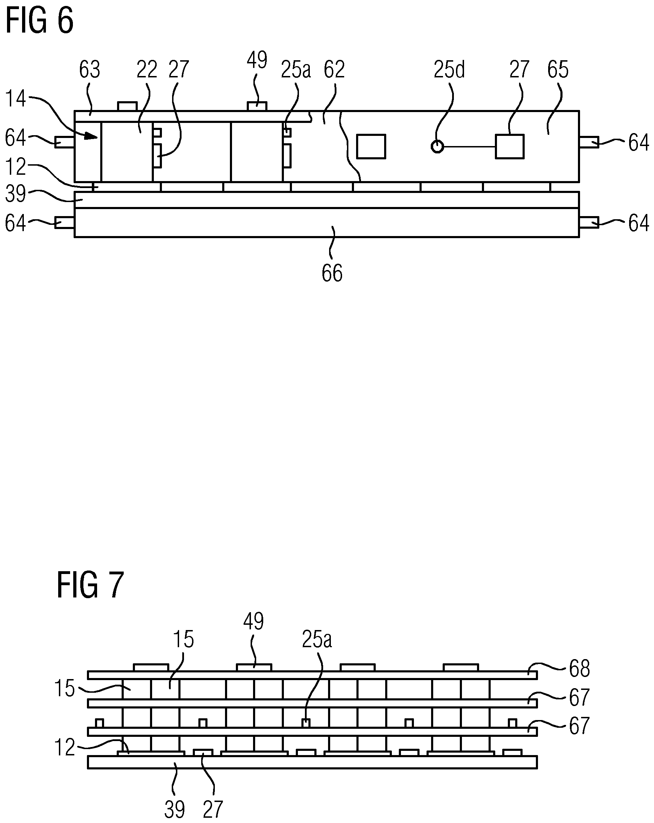

Der Schaltungsträger 24 ist als Zusatzschaltungsträger im Sinne der Erfindung zu verstehen. Die zusätzliche Funktion besteht im Ausführungsbeispiel gemäß Figur 1 im Tragen von Funktionskomponenten (integrierter Schaltkreis 24, Sensorelement 25a). Der Schaltungsträger 24 kann, wie in Figur 1 dargestellt, die Größe des Leistungsmoduls 11 aufweisen. In diesem Fall kann jedes Leistungsmodul mit einem gesonderten Schaltungsträger 24 versehen werden. Es ist aber auch möglich, den Schaltungsträger 24 mit einer größeren Fläche herzustellen, sodass dieser mehrere Leistungsmodule überspannt (in Figur 1 nicht dargestellt, vergleiche aber Figur 6 und 7) .

Als weitere Baustruktur sind an den Seitenkanten der Seitenwand 22 Rippen 30 als Versteifungsstruktur hergestellt. Diese können durch Umbiegen der Seitenkanten der Seitenwände 22 erzeugt werden. Die erste Elektrode 18 und die zweite Elektrode 19 können somit kostengünstig als Stanzgitter (Leadframe) durch Stanzen und anschließendes Biegen erzeugt werden. Durch Biegen können auch jeweils die Aufnahmestrukturen 23 und die Kontaktstrukturen 20 hergestellt werden.

In Figur 2 ist dargestellt, wie eine Kontaktierung der Kondensatoranordnung 14 gemäß Figur 1 mit einem als Transistor ausgeführten leistungselektronischen Bauelement 31 erfolgen kann. Zu diesem Zweck ist die Kontaktstruktur 20 über die Lötverbindung 21 mit einem Kontaktpad 32a kontaktiert, wobei das Kontaktpad 32a über eine Durchkontaktierung 33a mit einer Sourceelektrode 34 des leistungselektronischen Bauelements 31 kontaktiert ist. Die Sourceelektrode 34 ist außerdem über eine Leiterbahn 35 mit einem Distanzstück 36 verbunden, welches dieselbe Höhe wie das leistungselektronische Bauelement 31 aufweist.

Eine Drainelektrode 37 des leistungselektronischen Bauelements 31 ist über eine Kontaktfläche 38a und das Distanzstück 36 ist über eine Kontaktfläche 38b mit einem Basisschaltungsträger 39 verbunden. Der Basisschaltungsträger 39 stellt eine Grundplatte zur Verfügung, auf der die ganze elektronische Schaltung, bestehend aus mehreren Leistungsmodulen gemäß Figur 1, montiert ist (vgl. auch Figur 3).

Bei dem leistungselektronischen Bauelement gemäß Figur 2 handelt es sich um einen Transistor. Damit dieser geschaltet werden kann, ist weiterhin eine Gateelektrode 40 notwendig. Damit diese angesteuert werden kann, ist in der Substratplatte 12 eine Durchkontaktierung 33b vorgesehen, die von einem Kontaktpad 32b zu einem Kontaktpad 32c führt. Sourceelektrode 34, Gateelektrode 40, Drainelektrode 37 sowie Fügeschichten 41 am Distanzstück 36 sind z.B. als Sinterverbindungen ausgebildet.

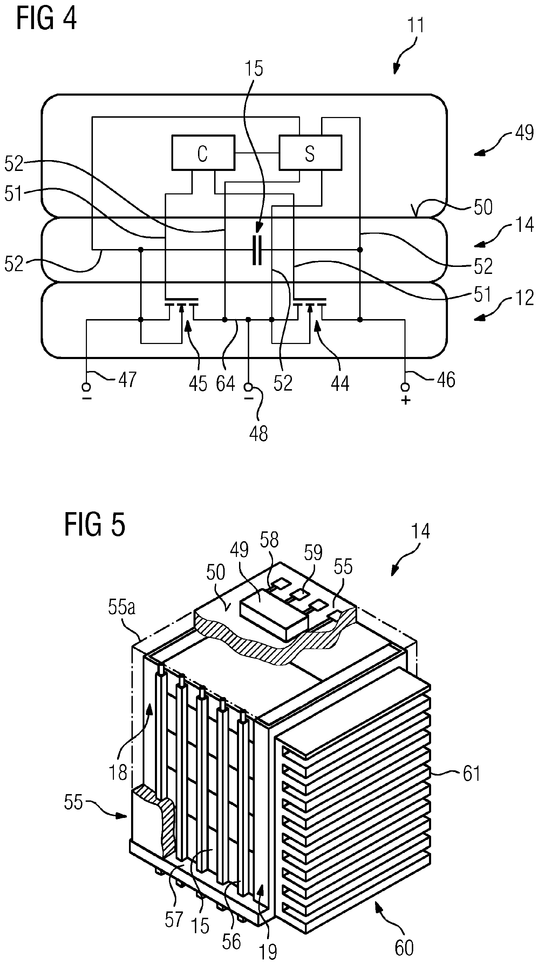

In Figur 3 ist dargestellt, wie mehrere Leistungsmodule 11 auf einem Basisschaltungsträger 39 gemäß Figur 2 zu einer leistungselektronischen Schaltung 42 kombiniert werden können. Fünf Leistungsmodule 11 sind jeweils zu einer Reihe 43 konfiguriert, wobei insgesamt sechs Reihen vorgesehen sind. Wie Figur 2 zu entnehmen ist, ist von der Substratplatte 12 nur die linke Seite dargestellt, wobei die rechte Seite ein weiteres leistungelektronisches Bauelement 31 aufweist (wie in Figur 6 dargestellt). Dies bedeutet, dass auf der nicht dargestellten Seite der Substratplatte gemäß Figur 2 ebenfalls ein Transistor als leistungselektronisches Bauelement verbaut ist. Hieraus ergibt sich eine Kontaktierungsmöglichkeit, die in Figur 3 für jedes Leistungsmodul 11 realisiert ist und in Figur 4 schematisch als beispielhaftes, nicht beanspruchtes Schaltbild dargestellt ist.

In Figur 4 ist der Kondensator 15 als Ersatz für den gesamten Kondensatoraufbau gemäß Figur 1 dargestellt. Dies dient der Vereinfachung der Darstellung, wobei alternativ auch eine Vielzahl parallel geschalteter Kondensatoren zum Einsatz kommen kann. Der Kondensator 15 gemäß Figur 4 wie auch der Kondensatoraufbau 14 ist lediglich schematisch dargestellt. Genauso verhält es sich mit der Substratplatte 12 und den darauf montierten leistungselektronischen Bauelementen, die durch einen ersten Transistor 44 und einen zweiten Transistor 45 ausgebildet sind. Der erste Transistor 44 ist mit seiner Source-Elektrode an den auch als High-Side bezeichneten Pluspol 46 angeschlossen, während der zweite Transistor 45 mit seiner Drain-Elektrode an den auch als Low-Side bezeichneten Minuspol 47 angeschlossen ist. Die Drain-Elektrode des ersten Transistors 44 ist mit der Source-Elektrode des zweiten Transistors 45 sind miteinander verbunden, wobei hierdurch eine Halbbrücke 64 mit einem Phasenkontakt 48 entsteht.

Zur Ansteuerung des Leistungsmoduls 11 ist der Kondensatoraufbau 14 mit einer Treiberschaltung 49 versehen, die gemäß Figur 5 beispielsweise auf einer Oberseite 50 des Kondensatoraufbaus 14 untergebracht sein kann.

Die Treiberschaltung gemäß Figur 4 ist nur schematisch dargestellt, um deren Funktion im Grundsatz zu beschreiben. Die Treiberschaltung weist eine Controllerfunktion C auf sowie eine Sensorfunktion S. Die Controllerfunktion wird durch Kontaktleitungen 51 als Schnittstelle zu den Gate-Elektroden des ersten Transistors 44 und des zweiten Transistors 45 gewährleistet. Damit kann die Treiberschaltung beide Transistoren als Schalter ansteuern. Die für diese Funktion notwendigen Informationen werden durch die Sensorfunktion S zur Verfügung gestellt. Die Sensorfunktion wird über Signalleitungen 52 gewährleistet, mit denen ein Stromfluss vor und hinter dem Kondensator 15 sowie vor und hinter dem Phasenkontakt 48 in der Halbbrücke 64 abgegriffen werden kann.

Der Kondensator 15 ist mit dem Pluspol 46 und dem Minuspol 47 verbunden und erfüllt damit eine Glättungsfunktion, die für einen mehrphasigen Betrieb der leistungselektronischen Schaltung 42 gemäß Figur 3 erforderlich ist.

Wie in Figur 3 zu erkennen ist, ist die leistungselektronische Schaltung 42 gemäß Figur 3 modular aufgebaut. Mittels der durch die Leistungsmodule 11 gemäß Figur 4 realisierten Schaltung können diese in drei Gruppen jeweils gemeinsam verwendet werden, um aus einer am gemeinsamen Pluspol 46p und am gemeinsamen Minuspol 47m anliegenden Gleichspannung eine dreiphasige Wechselspannung zu erzeugen, die an den gemeinsamen Phasenkontakten 48a, 48b, 48c abgegriffen werden kann. Die Höhe des zu schaltenden maximalen Stroms bestimmt, wie viele der Leistungsmodule 11 pro Phase zum Einsatz kommen müssen. Gemäß Figur 3 handelt es sich um jeweils zehn Leistungsmodule 11 pro Phase.

Wie zu erkennen ist, sind die Elektroden 53m, 53p des Pluspols 46p und des Minuspols 47m kammartig ausgebildet, so dass jeweils durch die den Pluspol 46p bildende Elektrode 53p jeder erste Transistor 44 jedes Leistungsmoduls 11 und mit der den Minuspol 53m Elektrode 53m jeder zweite Transistor 45 jedes Leistungsmoduls 11 kontaktiert werden kann. Die Phasenkontakte 48a, 48b, 48c sind jeweils mit U-förmigen Elektroden 54a, 54b, 54c verbunden, welche jeweils im mittleren Bereich der Leistungsmodule 11 sowohl den ersten Kondensator 44 als auch den zweiten Kondensator 45 kontaktieren und auf diese Weise jeweils eine der drei Gruppen von je zehn Leistungsmodulen 11 über eine Halbbrücke (64 in Figur 4) kontaktieren.

Damit ist für jedes der Leistungsmodule 11 eine Schaltung gemäß Figur 4 realisiert, wobei jede Gruppe von Leistungsmodulen 11 parallel geschaltet ist.

Bei der Kondensatoranordnung 14 gemäß Figur 5 kommen eine erste Elektrode 18 und die zweite Elektrode 19 zum Einsatz, um die Kondensatoren 15 in der zu Figur 1 beschriebenen Weise zu kontaktieren. Gemäß Figur 5 sind fünf Kondensatoren 15 übereinander und je zwei Kondensatoren nebeneinander angeordnet. Der Kondensatoraufbau 14 weist anders als in Figur 1 ein elektrisch isolierendes Material 55 auf. Dieses besteht gemäß Figur 5 aus Kunststoff, wobei die erste Elektrode 18 und die zweite Elektrode 19 derart in das Material 55 eingespritzt ist, dass eine Kontaktierung mit den Kondensatoren 15 erfolgen kann (sog. Montagespritzgießen).

Das Material 55 ist in Figur 5 nur ausschnittweise dargestellt. Die durch das Material 55 gebildete Gehäusestruktur ist weitgehend aufgebrochen, wobei lediglich die Konturen 55a, die durch das Material 55 gebildet sind, mit Strichpunktlinien angedeutet sind. Daher können die im Inneren des Materials angedeuteten Strukturen in Figur 5 erkannt werden. Dazu zählen neben der ersten Elektrode 18 und der zweiten Elektrode 19 sowie den Kondensatoren 15 auch elektrische Leitpfade 56, die durch metallische Leiter gebildet sind und die Oberseite 50 elektrisch mit der Montageseite der Kondensatoranordnung 14 verbinden. Die Leitpfade bilden auf der Montageseite Kontaktstrukturen 57 aus, die auf einer Substratplatte (vgl. 12 in Figur 1) kontaktiert werden können, wenn auf dieser entsprechende Kontaktpads vorhanden sind.

Auf der Oberseite 50 kann die Treiberschaltung 49 gemäß Figur 4 angeordnet werden. Damit diese die auf der Substratplatte gemäß Figur 2 angeordneten leistungselektronischen Bauelemente 31 ansteuern kann, können die Leitpfade 56 genutzt werden. Auf der Oberseite 15 sind zu diesem Zweck Leiterbahnen 58 und Kontaktpads 59 vorgesehen, wobei die Kontaktpads 59 mit den Leitpfaden 56 in elektrischer Verbindung stehen.

Die durch die Elektrode 19 gebildete Seitenwand wird zusätzlich zur Unterbringung einer Kühlvorrichtung 60 als Baustruktur verwendet, wobei die Kühlvorrichtung 60 aus einem passiven Aluminiumkühler mit Rippen 61 besteht. Alternativ (nicht dargestellt) könnte auch ein aktiver Kühler mit einem Kühlkanal verwendet werden, der einen Zulauf und einen Ablauf für ein vorzugsweise flüssiges Kühlmedium aufweist.

Die durch das Material 55 gebildete Gehäusestruktur ist als Trägerbauteil im Sinne der Erfindung zu verstehen. Diese trägt beispielsweise als Funktion die Treiberschaltung 49. Auch die Kühlvorrichtung 60 ist als Trägerbauteil im Sinne der Erfindung zu verstehen. Diese kann direkt an der Elektrode 19 befestigt sein, um eine möglichst direkte Wärmeleitung zu gewährleisten. Alternativ kann das Material 55 der Gehäusestruktur auch im Bereich der Elektrode 19 vorhanden sein, um eine Isolation zu gewährleisten. In diesem Fall ist die Kühlvorrichtung 60 als Trägerbauteil auf dem durch das Material 55 gebildeten Trägerbauteil befestigt. Wie in Figur 5 dargestellt, ist außerdem die Kühlvorrichtung 60 nur an dem in Figur 5 abgebildeten Kondensatoraufbau 14 befestigt. Es ist aber auch möglich, dass die Kühlvorrichtung 60 in Richtung der Rippen länger ist, so dass auch benachbarte (nicht dargestellte) Kondensatoraufbauten mit der Kühlvorrichtung kontaktiert werden können (vgl. auch Figur 6).

Gemäß Figur 6 ist ein Basisschaltungsträger 39 dargestellt, auf dem mehrere Leistungsmodule, bestehend aus jeweils den Substratplatten 12 und den Kondensatoraufbauten 14 (die in Figur 6 nicht detailliert dargestellt sind) bestehen. Wie Figur 6 zu entnehmen ist, sind die Leistungsmodule in einer Reihe parallel zur Zeichenebene angeordnet. Hinter den dargestellten Leistungsmodulen können weitere Leistungsmodule liegen, die benachbarte Reihen ausbilden, welche hinter der Zeichenebene liegen. Insofern ist der Aufbau gemäß Figur 6 auch als Matrixanordnung analog zu Figur 3 ausführbar.

Dies gilt sinngemäß auch für Figur 7. Hier sind die Leistungsmodule ebenfalls auf dem Basisschaltungsträger 39 angeordnet und liegen in einer Reihe parallel zur Zeichenebene. Hinter diesen Leistungsmodulen können weitere Leistungsmodule liegen, die in Figur 7 nicht zu erkennen sind, wobei sich ein Aufbau in einer Matrix analog zu Figur 3 ergibt.

In Figur 6 kommt als Trägerbauteil ein Zusatzschaltungsträger 63 zum Einsatz, auf dem die Treiberschaltungen 49 montiert sind. Der Zusatzschaltungsträger 63 weist daher nicht näher dargestellte Leiterbahnen auf, die eine elektrische Kontaktierung der Treiberschaltungen 49 mit den Leistungsbauelementen (in Figur 6 nicht dargestellt) ermöglichen. Dies kann beispielsweise, wie in Figur 5 dargestellt, mit Leitpfaden 56 erfolgen. Der Zusatzschaltungsträger 63 erstreckt sich dabei über die dargestellte Reihe von Kondensatoraufbauten 14 und kann sich überdies auch über dahinter liegende Kondensatoraufbauten erstrecken, wenn diese als Matrix analog zu Figur 3 angeordnet sind (nicht näher dargestellt). Besonders vorteilhaft kann die Ausdehnung des Zusatzschaltungsträger 63 in Richtung der Zeichenebene und senkrecht dazu genau den Abmessungen des Basisschaltungsträgers 39 entsprechen.

An den Seitenwänden 22 der Kondensatoraufbauten 14 können weitere Trägerbauteile montiert sein. Das Trägerbauteil besteht ebenfalls aus einem Zusatzschaltungsträger 65, auf dem beispielsweise Vibrationssensoren 25d mit integrierten Schaltkreisen 27 zur Ansteuerung montiert sein können. Der Zusatzschaltungsträger 65 ist an jeweils einer Seitenwand 22 aller Kondensatoraufbauten 14 befestigt, die zu den in Figur 6 dargestellten Leistungsmodulen gehören. Diese Seitenwände sind dem Betrachter zugewandt und durch die teilweise aufgebrochene Darstellung hinter dem Zusatzschaltungsträger 65 zu erkennen.

Auf der dem Betrachter abgewandten Seite der Leistungsmodule ist eine Kühlvorrichtung 65 in Form eines Flüssigkeitskühlers angeordnet. Diese weist Anschlüsse 64 auf, durch die ein Kühlfluid zugeführt bzw. abgeführt werden kann. Die Kühlvorrichtung 65 erstreckt sich ebenfalls über die ganze in Figur 6 dargestellte Reihe an Leistungsmodulen, so dass diese gemeinsam gekühlt werden können.

Alternativ oder zusätzlich kann in an sich bekannter Weise eine weitere Kühlvorrichtung 66 auf der den Leistungsmodulen gegenüberliegenden Seite des Basisschaltungsträgers 69 vorgesehen werden. Auch diese ist als Flüssigkeitskühler ausgeführt und hat deswegen Anschlüsse 64. Alternativ (nicht dargestellt) kann auch ein passiver Rippenkühler oder dergleichen verwendet werden.

Gemäß Figur 7 ist ein Aufbau dargestellt, bei dem zusätzlich zum Basisschaltungsträger 39 zwei Zwischenschaltungsträger 67 zum Einsatz kommen, die somit die Funktion von Zusatzschaltungsträgern übernehmen. Als weiteres Trägerbauteil ist oben auf den Kondesatoren ein Zusatzschaltungsträger 68 vorgesehen, auf dem, wie zu Figur 6 beschrieben, die Treiberschaltungen 49 montiert sind. Dieses weitere Trägerbauteil schließt die gesamte Baugruppe nach oben hin ab.

Die Zwischenschaltungsträger 67 dienen in einer ersten Alternative zur Montage der Kondensatoren 15. Dadurch, dass der Basisschaltungsträger 39 die Substratplatten 12 und diese ihrerseits je zwei Kondensatoren 15 tragen und auf jeder der beiden Zwischenschaltungsträger 67 ebenfalls zwei Kondensatoren 15 montiert sind, bilden die Kondensatoren der Substratplatten 12 und der Zwischenschaltungsträger 67 für jedes Leistungsmodul jeweils sechs übereinander und nebeneinander liegende Kondensatoren, die gemeinsam jeweils die Kondensatoraufbauten ergeben. Die Kondensatoren 15 verschiedener Ebenen sind dabei jeweils durch einen der Zwischenschaltungsträger 67 voneinander getrennt, wobei über die Zwischenschaltungsträger 67 auch eine elektrische Parallelschaltung der Kondensatoren erfolgen kann. Die Basisplatte 39, die Zwischenschaltungsträger 67 sowie das zusätzliche Trägerbauteil, welches vorzugsweise als Zusatzschaltungsträger 68 ausgebildet sein kann (vgl. das zum Zusatzschaltungsträger 63 in Figur 6 Angeführte), können jeweils identische Flächen aufweisen und daher fluchtend übereinander angeordnet werden.

Nach einer zweiten Alternative gemäß Figur 6 ist es auch möglich, dass die Zwischenschaltungsträger 67 Öffnungen aufweisen, in die die Kondensatoraufbauten genau hineinpassen. Die Kondensatoraufbauten sind beispielsweise gemäß Figur 1 ausgeführt, sodass diese eigenständige Baueinheiten ergeben, die auf dem Basisschaltungsträger 39 montiert sind. Die Zwischenschaltungsträger 67 können dann mit ihren Öffnungen über die Kondensatoraufbauten geschoben werden, wobei sich dieselbe Seitenansicht gemäß Figur 7 ergibt, welche durch die 1. Alternative gegeben ist. Die Zwischensschaltungsträger können beispielsweise gestanzt werden, um die Öffnungen zu erzeugen, durch die die Kondensatoraufbauten geschoben werden.

## Patentansprüche

1. Leistungselektronische Schaltung (42) mit einer Vielzahl von miteinander verschalteten Leistungsmodulen (11), wobei die Leistungsmodule (11)
• jeweils mindestens ein leistungselektronisches Bauelement (31), insbesondere einen Transistor, aufweisen,
• mehrere parallel geschaltete und mit dem mindestens einen leistungselektronischen Bauelement (31) elektrisch verbundene Kondensatoren (15) aufweisen, wobei die Leistungsmodule (11) derart ausgebildet sind, dass
• die leistungselektronischen Bauelemente (31) auf der einen Seite von Substratplatten (12) montiert sind,
• die Kondensatoren (15) in mehreren Ebenen übereinander auf der anderen Seite der Substratplatten (12) montiert sind, wobei die Substratplatten (12) mit den leistungselektronischen Bauelementen (31) voran nebeneinander auf einer Montageseite eines Basisschaltungsträgers (39) befestigt sind.

2. Leistungselektronische Schaltung (42) nach Anspruch 1, wobei auf der Montageseite des Basisschaltungsträgers (39) eine Schaltung ausgebildet ist, über die die leistungselektronischen Bauelemente (31) der Leistungsmodule (11) elektrisch kontaktiert sind.

3. Leistungselektronische Schaltung (42) nach einem der voranstehenden Ansprüche, wobei die Leistungsmodule (11) in einer Reihe (43) angeordnet sind.

4. Leistungselektronische Schaltung (42) nach einem der Ansprüche 1 oder 2, wobei die Leistungsmodule (11) in einem zweidimensionalen Array in einer Vielzahl benachbarter Reihen (43) angeordnet sind.

5. Leistungselektronische Schaltung (42) nach einem der voranstehenden Ansprüche, wobei ein Trägerbauteil (24, 62, 63, 65, 66, 67, 68) für eine Zusatzfunktion vorgesehen ist, welches zumindest mit einem Teil der Leistungsmodule (11) mechanisch verbunden ist.

6. Leistungselektronische Schaltung (42) nach Anspruch 5, wobei das Trägerbauteil auf den dem Basisschaltungsträger (39) abgekehrten Seiten der Leistungsmodule (11) befestigt ist.

7. Leistungselektronische Schaltung (42) nach Anspruch 6, wobei das Trägerbauteil aus einem Zwischenschaltungsträger (67) besteht und auf einer den leistungselektronischen Bauelementen (31) abgekehrten Seite des Zwischenschaltungsträgers mehrere parallel geschaltete und mit dem mindestens einen leistungselektronischen Bauelement elektrisch verbundene Kondensatoren (15) aufweist.

8. Leistungselektronische Schaltung (42) nach Anspruch 7, wobei auf den Kondensatoren (15) des Zwischenschaltungsträgers mindestens ein weiteres Trägerbauteil für eine Zusatzfunktion befestigt ist.

9. Leistungselektronische Schaltung (42) nach einem der voranstehenden Ansprüche, wobei das Trägerbauteil sich entlang benachbarter Leistungsmodule (11) erstreckt und an jeweiligen durch diese gebildeten Seitenflächen befestigt ist.

10. Leistungselektronische Schaltung (42) nach einem der Ansprüche 1 bis 6 oder 8 bis 9, wobei das Trägerbauteil aus einer Kühlvorrichtung (60, 62) besteht.

11. Leistungselektronische Schaltung (42) nach einem der Ansprüche 1 bis 6 oder 8 bis 10, wobei das Trägerbauteil aus einem Zusatzschaltungsträger (24, 63, 65, 68) mit einer Schaltung (27) besteht.

12. Leistungselektronische Schaltung (42) nach Anspruch 11, wobei auf dem Zusatzschaltungsträger (24, 63, 65, 68) mindestens als Schaltung eine Treiberschaltung (49) für die leistungselektronische Schaltung (42) und/oder zumindest einen Teil der Leistungsmodule (11) angeordnet ist.

13. Leistungselektronische Schaltung (42) nach einem der voranstehenden Ansprüche, wobei das Trägerbauteil als Zusatzfunktion mindestens ein Sensorelement (25a, 25b, 25c), insbesondere ein Temperatursensor und/oder ein Feuchtigkeitssensor und/oder ein Stromsensor und/oder ein Beschleunigungssensor angeordnet aufweist.

14. Leistungselektronische Schaltung (42) nach einem der voranstehenden Ansprüche, wobei das Trägerbauteil als Zusatzfunktion eine mechanische Versteifungsstruktur, insbesondere Rippen (30), aufweist.

15. Leistungselektronische Schaltung (42) nach einem der voranstehenden Ansprüche, wobei
• jedes Leistungsmodul (11) zwei als Schaltelemente ausgeführte leistungselektronische Bauelemente (31) aufweist,
• die leistungselektronischen Bauelemente (31) jedes Leistungsmoduls (11) eine Halbbrücke (48) bilden,
• die leistungselektronischen Bauelemente (31) in drei Gruppen verschaltet sind, derart, dass jede Gruppe einer Phase eines dreiphasigen Wechselstroms zugeordnet ist, wobei jede Gruppe mit einem Gleichstrom beaufschlagbar ist.

## Claims

1. Power electronic circuit (42) having a plurality of interconnected power modules (11), wherein the power modules (11)
• each have at least one power electronic element (31), in particular a transistor,
• have a plurality of capacitors (15) which are wired in parallel and are electrically connected to the at least one power electronic element (31),
wherein the power modules (11) are designed in such a way that
• the power electronic elements (31) are mounted on one side of substrate plates (12),
• the capacitors (15) are mounted in a plurality of planes one above the other on the other side of the substrate plates (12), wherein the substrate plates (12), with the power electronic elements (31) forward and alongside each other, are fixed onto an assembly side of a base circuit carrier (39).

2. Power electronic circuit (42) according to claim 1, wherein a circuit, by means of which the power electronic elements (31) of the power modules (11) are electrically contacted, is formed on the assembly side of the base circuit carrier (39).

3. Power electronic circuit (42) according to one of the preceding claims,
wherein the power modules (11) are arranged in a row (43).

4. Power electronic circuit (42) according to one of claims 1 or 2,
wherein the power modules (11) are arranged in a twodimensional array in a plurality of adjacent rows (43).

5. Power electronic circuit (42) according to one of the preceding claims,
wherein a carrier component (24, 62, 63, 65, 66, 67, 68) which is mechanically connected to at least some of the power modules (11) is provided for an additional function.

6. Power electronic circuit (42) according to claim 5, wherein the carrier component is fixed onto those sides of the power modules (11) which face away from the base circuit carrier (39).

7. Power electronic circuit (42) according to claim 6, wherein the carrier component consists of an intermediate circuit carrier (67) and, on a side of the intermediate circuit carrier which faces away from the power electronic elements (31), has a plurality of capacitors (15) which are wired in parallel and are electrically connected to the at least one power electronic element.

8. Power electronic circuit (42) according to claim 7, wherein at least one further carrier component for an additional function is fixed onto the capacitors (15) of the intermediate circuit carrier.

9. Power electronic circuit (42) according to one of the preceding claims,
wherein the carrier component extends along adjacent power modules (11) and is fixed onto respective side faces formed thereby.

10. Power electronic circuit (42) according to one of claims 1 to 6 or 8 to 9,
wherein the carrier component consists of a cooling device (60, 62).

11. Power electronic circuit (42) according to one of claims 1 to 6 or 8 to 10,
wherein the carrier component consists of an additional circuit carrier (24, 63, 65, 68) with a circuit (27).

12. Power electronic circuit (42) according to claim 11, wherein at least a driver circuit (49) for the power electronic circuit (42) and/or at least some of the power modules (11) are arranged on the additional circuit carrier (24, 63, 65, 68) as a circuit.

13. Power electronic circuit (42) according to one of the preceding claims,
wherein the carrier component has at least one sensor element (25a, 25b, 25c), in particular a temperature sensor and/or a humidity sensor and/or a current sensor and/or an acceleration sensor, as an additional function.

14. Power electronic circuit (42) according to one of the preceding claims,
wherein the carrier component has a mechanical stiffening structure, in particular ribs (30), as an additional function.

15. Power electronic circuit (42) according to one of the preceding claims,
wherein
• each power module (11) has two power electronic elements (31) embodied as switching elements,
• the power electronic elements (31) of each power module (11) form a half bridge (48),
• the power electronic elements (31) are interconnected in three groups, such that each group is assigned to a phase of a three-phase alternating current, wherein each group can receive a direct current.

## Revendications

1. Circuit (42) électronique de puissance ayant une pluralité de modules (11) de puissance connectés entre eux, dans lequel les modules (11) de puissance
• ont chacun au moins un composant (31) électronique de puissance, notamment un transistor,
• ont plusieurs condensateurs (15) montés en parallèle et connectés électriquement au au moins un composant (31) électronique de puissance,
dans lequel les modules (11) de puissance sont constitués
• de manière à ce que les composants (31) électroniques de puissance soient montés sur l'une des faces de plaques (12) de substrat,
• de manière à ce que les condensateurs (15) soient montés en plusieurs plans les uns sur les autres sur l'autre face des plaques (12) de substrat, les plaques (12) de substrat étant fixées avec les composants électroniques de puissance devant les unes à côté des autres sur une face de montage d'un support (39) de circuit de base.

2. Circuit (42) électronique de puissance suivant la revendication 1,
dans lequel sur la face de montage du support (39) de circuit de base est constitué un circuit par lequel les composants (31) électroniques de puissance des modules (11) de puissance sont mis en contact électriquement.

3. Circuit (42) électronique de puissance suivant l'une des revendications précédentes,
dans lequel les modules (11) de puissance sont disposés suivant une rangée (43).

4. Circuit (42) électronique de puissance suivant l'une des revendications 1 ou 2,
dans lequel les modules (11) de puissance sont disposés suivant un réseau à deux dimensions en une pluralité de rangées (43) voisines.

5. Circuit (42) électronique de puissance suivant l'une des revendications précédentes,
dans lequel il est prévu un élément (24, 62, 63, 65, 66, 67, 68) de support pour une fonction supplémentaire, qui est relié mécaniquement à au moins une partie des modules (11) de puissance.

6. Circuit (42) électronique de puissance suivant la revendication 5,
**caractérisé en ce que** l'élément de support est fixé au côté, loin du support (39) de circuit de base, des modules (11) de puissance.

7. Circuit (42) électronique de puissance suivant la revendication 6,
**caractérisé en ce que** l'élément de support est constitué d'un support (67) de circuit intermédiaire et a d'un côté, loin des composants électroniques de puissance, du support de circuit intermédiaire plusieurs condensateurs (15) montés en parallèle et reliés électriquement au au moins un composant (31) électronique de puissance.

8. Circuit (42) électronique de puissance suivant la revendication 7,
dans lequel au moins un autre élément de support pour une fonction supplémentaire est fixé sur les condensateurs (15) du support de circuit intermédiaire.

9. Circuit (42) électronique de puissance suivant l'une des revendications précédentes,
dans lequel l'élément de support s'étend le long de modules (11) de puissance voisins et est fixé à des surfaces latérales respectives formées par ceux-ci.

10. Circuit (42) électronique de puissance suivant l'une des revendications 1 à 6 ou 8 à 9,
dans lequel l'élément de support est constitué d'un dispositif (60, 62) de refroidissement.

11. Circuit (42) électronique de puissance suivant l'une des revendications 1 à 6 ou 8 à 10,
dans lequel l'élément de support est constitué d'un support (24, 63, 65, 68) de circuit supplémentaire ayant un circuit (27).

12. Circuit (42) électronique de puissance suivant la revendication 11,
dans lequel sur le support (24, 63, 65, 68) de circuit supplémentaire est disposé, au moins comme circuit, un circuit (49) d'attaque du circuit (42) électronique de puissance et/ou au moins une partie des modules (11) de puissance.

13. Circuit (42) électronique de puissance suivant l'une des revendications précédentes,
dans lequel l'élément de support à monter en fonction supplémentaire a au moins un élément (25a, 25b, 25c) capteur, notamment un capteur de température et/ou un capteur d'humidité et/ou un capteur de courant et/ou un capteur d'accélération.

14. Circuit (42) électronique de puissance suivant l'une des revendications précédentes,
dans lequel l'élément de support a comme fonction supplémentaire une structure de raidissement mécanique, notamment des nervures (30).

15. Circuit (42) électronique de puissance suivant l'une des revendications précédentes, dans lequel
• chaque module (11) de puissance a deux composants (31) électroniques de puissance réalisés en éléments de coupure,
• les composants (31) électroniques de puissance de chaque module (11) de puissance forment un demi-pont (48),
• les composants (31) électroniques de puissance sont connectés en trois groupes, de manière à associer chaque groupe à une phase d'un courant alternatif triphasé, chaque groupe pouvant être alimenté en un courant continu.
